# EUROPEAN PATENT APPLICATION

(11) **EP 4 094 822 A1**
(43) Date of publication of application: **30.11.2022**
(21) Application number: 22160506.6
(22) Date of filing: 07.03.2022
(51) Int. Cl.: B01D 53/86, B01D 53/88

(54) **NOX REDUCTION SYSTEM**

(30) Priority: 28.05.2021 KR 20210068815
(71) Applicant: Triple Cores Korea Co., Ltd., Gyeonggi-do 17086 (KR)
(72) Inventor: Kim, Ik Nyun, 06676 Seoul (KR); Kim, Hyoung Suk, 15337 Ansan-si, Gyeonggi-do (KR); You, Jae Bong, 17600 Anseong-si, Gyeonggi-do (KR)
(74) Representative: RGTH

(57) **Abstract**

A nitrogen oxide reduction system according to an embodiment includes a pre-treatment unit for reducing particulate matter and chemical gas included in an introduced gas by a pre-treatment of the gas, a reaction unit for reducing nitrogen oxide and ammonia from the gas passed through the pre-treatment unit, and a post-treatment unit for controlling temperature and pressure of a discharged gas by a post-treatment of the gas passed through the reaction unit, in which the reaction unit includes a heater for heating the gas to a preset temperature range, and a reaction chamber connected in back of the heater to reduce nitrogen oxide and ammonia.

## Description

### TECHNICAL FIELD

The disclosure relates to a NOx reduction system.

### BACKGROUND ART

Nitrogen oxide (NOx), which refers to a compound consisting of nitrogen and oxygen, or combination thereof, is considered to be the cause of environmental pollution and hazardous to the human body. Therefore, there are widespread efforts to reduce or remove NOx.

Particularly, in order to efficiently reduce nitrogen oxide generated in the semiconductor manufacturing process, a system capable of reducing a large amount of nitrogen oxide is required, but the related system shows limitations in view of maintenance cost and thermal efficiency for reaction.

In addition, the nitrogen oxide reduction system requires regular maintenance to keep the reduction efficiency above certain level, and disassembly and assembly of the system are frequently required for the maintenance. However, difficulty level of work is high due to big weight, and there are risks such as safety accidents.

### SUMMARY

### Technical Problem

Accordingly, a method for reducing nitrogen oxide more efficiently is required in the art.

### Technical Solution

In order to solve the above problems, a nitrogen oxide reduction system according to an embodiment is provided.

The nitrogen oxide reduction system may include a pre-treatment unit for reducing particulate matter and chemical gas included in an introduced gas by a pre-treatment of the gas, a reaction unit for reducing nitrogen oxide and ammonia from the gas passed through the pre-treatment unit, and a post-treatment unit for controlling temperature and pressure of a discharged gas by a post-treatment of the gas passed through the reaction unit, in which the reaction unit includes a heater for heating the gas to a preset temperature range, and a reaction chamber connected in back of the heater to reduce nitrogen oxide ammonia.

In addition, the technical solution discussed above do not enumerate all the features of the present invention. Various features of the present invention and its advantages and effects may be understood in more detail with reference to the following specific embodiments.

### Advantageous Effects

According to one embodiment of the present invention, by forming a nitrogen oxide reduction chamber and an ammonia reduction chamber as an integrated reaction chamber, heat loss due to gas movement can be minimized, and nitrogen oxide and ammonia can be reduced with a single heater without the need for an additional heater.

The nitrogen oxide reduction chamber or the ammonia reduction chamber can be formed such that a plurality of unit chambers formed as modules are coupled with each another in a stacked manner, and thus, the reaction efficiency of the reaction chamber can be maximized by varying the catalyst supply cycle according to use of the catalyst in each of a plurality of unit chambers.

Among the components of the nitrogen oxide reduction system, the components requiring separation for regular maintenance are moved horizontally from a side of the housing system and coupled to the lower surface of the housing system, thus allowing easier maintenance work of the nitrogen oxide reduction system and also ensuring safety.

### BRIEF DESCRIPTION OF THE DRAWING

FIG. 1 is a block diagram of a nitrogen oxide reduction system according to an embodiment.
FIG. 2 is a detailed block diagram of the pre-treatment unit shown in FIG. 1.
FIG. 3 is a detailed block diagram of the reaction unit shown in FIG. 1.
FIG. 4 illustrates an implementation of the reaction chamber shown in FIG. 3.
FIG. 5 is a detailed block diagram of the post-treatment unit shown in FIG. 1.
FIG. 6 is a view showing an implementation of a nitrogen oxide reduction system according to an embodiment.

### DETAILED DESCRIPTION

Hereinafter, preferred embodiments of the present invention will be described in detail with reference to the accompanying drawings so that those with ordinary knowledge in the art can easily achieve the present invention. However, in describing preferred embodiments of the present invention in detail, a detailed description of known functions and configurations incorporated herein will be omitted when it may unnecessarily make the subject matter of the present invention rather unclear. In addition, same reference numerals are used throughout the drawings for parts having similar functions and operations.

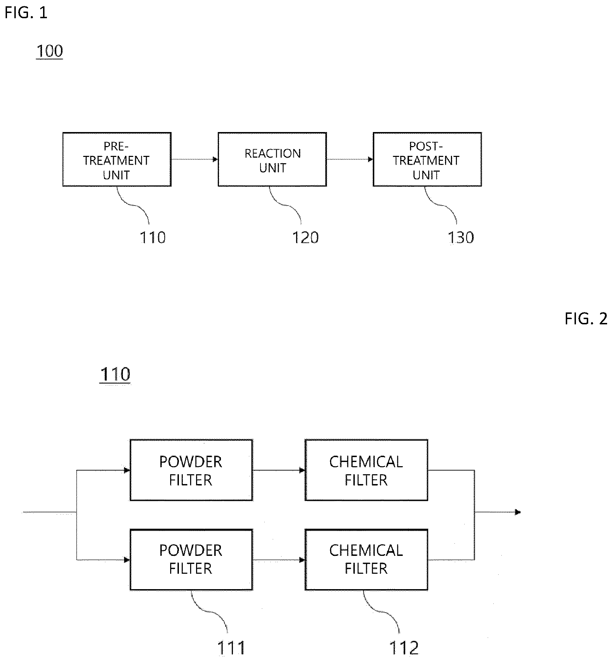

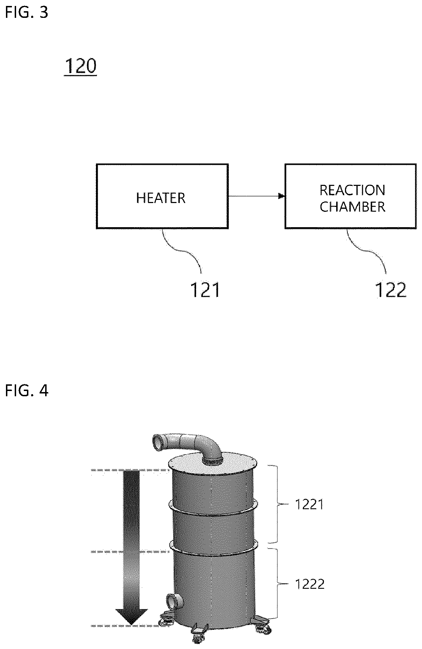

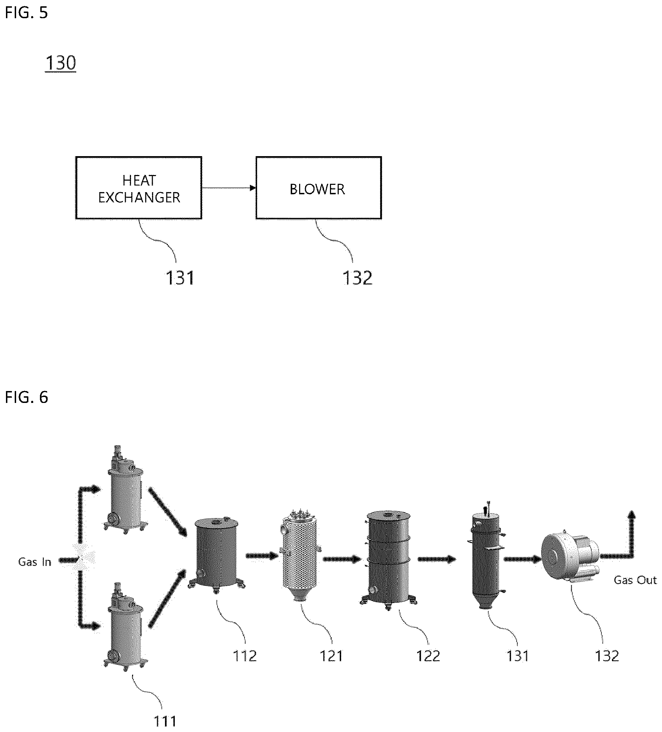

FIG. 1 is a block diagram of a nitrogen oxide reduction system according to an embodiment, FIG. 2 is a detailed block diagram of the pre-treatment unit shown in FIG. 1, FIG. 3 is a detailed block diagram of the reaction unit shown in FIG. 1, FIG. 4 is a view showing an embodiment of the reaction chamber shown in FIG. 3, and FIG. 5 is a detailed block diagram of the post-treatment unit shown in FIG. 1.

Referring to FIGS. 1 to 5, the nitrogen oxide reduction system 100 according to an embodiment may include a pre-treatment unit 110, a reaction unit 120, and a post-treatment unit 130.

In an embodiment, the pre-treatment unit 110 is provided for the pre-treatment of gas introduced from a semiconductor process, and can reduce particulate matter (e.g., powder, etc.) and chemical gas (e.g., acid exhaust gas) included in the gas, for example, by the pre-treatment of the gas.

According to an embodiment, the pre-treatment unit 110 may include a powder filter 111 for removing the powder in the gas and a chemical filter 112 for removing the chemical gas, as shown in FIG. 2.

In addition, the pre-treatment unit 110 may be configured in dual configuration in which the powder filter 111 and the chemical filter 112 in back of the powder filter 111 are connected in parallel. This dual configuration of the powder filter 111 and chemical filter 112 lines allows continuous operation through mutual backup.

The reaction unit 120 is provided to reduce nitrogen oxide and ammonia from the gas passed through the pre-treatment unit 110.

According to an embodiment, the reaction unit 120 may include a heater 121 and a reaction chamber 122 connected in back of the heater 121, as shown in FIG. 3.

The heater 121 may heat the gas to increase the temperature to degrees at which nitrogen oxide and ammonia can be reduced. For example, the heater 121 may heat the gas to a temperature range (230 to 250 °C) at which nitrogen oxide can be reduced by the Selective Catalytic Reduction (SCR), but embodiments are not limited hereto, and the heater 121 may heat the gas to a preset temperature according to the nitrogen oxide reduction method used.

The reaction chamber 122 is provided to reduce nitrogen oxide and ammonia in the gas heated by the heater 121, and may include a nitrogen oxide reduction chamber 1221 for reducing nitrogen oxide and an ammonia reduction chamber 1222 for reducing ammonia.

According to an embodiment, the nitrogen oxide reduction chamber 1221 may reduce nitrogen oxide by SCR as described above. However, the nitrogen oxide reduction method is not necessarily limited thereto, and may be implemented by applying various nitrogen oxide reduction techniques known to those skilled in the art.

Further, the ammonia reduction chamber 1222 may reduce ammonia from the gas passed through the nitrogen oxide reduction chamber 1221 by using ammonia oxidation catalyst (NH₃ oxidation catalyst). Again, the ammonia reduction method is not necessarily limited to the above, and may be implemented by applying various ammonia reduction techniques known to those skilled in the art.

According to an embodiment, the nitrogen oxide reduction chamber 1221 and the ammonia reduction chamber 1222 may be coupled to each another in a stacked manner as shown in FIG. 4, and may be implemented as an integral reaction chamber 122.

In this case, they may be coupled such that the nitrogen oxide reduction chamber 1221 is positioned above and the ammonia reduction chamber 1222 is positioned under, in which the gas heated with the heater 121 may be introduced from an upper portion of the nitrogen oxide reduction chamber 1221 and moved toward a lower portion while passing through the ammonia reduction chamber 1222.

According to the embodiment described above, the gas heated to 230 to 250 °C by the heater 121 is first introduced into the nitrogen oxide reduction chamber 1221 where the nitrogen oxide are reduced by SCR, and the gas after the nitrogen oxide reduction is introduced into the ammonia reduction chamber 1222 coupled to the lower portion of the nitrogen oxide reduction chamber 1221 so that ammonia can be reduced by the ammonia oxidation catalyst.

In the above process, the temperature of the gas can be maintained at 200 to 230 °C, although the temperature of the gas naturally decreases along the movement of the gas. Accordingly, by forming the nitrogen oxide reduction chamber 1221 and the ammonia reduction chamber 1222 as the integral reaction chamber 122, heat loss due to gas movement can be minimized, and thus, the need to re-heat the gas to proper temperature for reducing ammonia is eliminated. That is, both the nitrogen oxide and ammonia can be reduced with the single heater 121 and there is no need to additionally include a separate heater.

Also, the nitrogen oxide reduction chamber 1221 may be formed such that a plurality of unit chambers formed as modules are coupled to one another in a stacked manner. While FIG. 4 shows an example in which the nitrogen oxide reduction chamber 1221 includes two unit chambers, the embodiments are not limited hereto, and various modifications are possible according to needs, by adjusting the capacity of each unit chamber or the number of unit chambers to be coupled. Further, although the ammonia reduction chamber 1222 is illustrated as one chamber in FIG. 4, the ammonia reduction chamber 1222 may be also formed of a plurality of unit chambers as described above.

When the gas is introduced from the upper portion of the reaction chamber 122, the ratio of nitrogen oxide and ammonia included in the gas is relatively high at the front end of the reaction chamber 122, i.e., the nitrogen oxide reduction chamber 1221 and the ammonia reduction chamber 1222, and thus, the catalyst provided into the chamber is exhausted faster at the front end compared to the rear end.

As described above, when the nitrogen oxide reduction chamber 1221 or the ammonia reduction chamber 1222 is configured with a plurality of unit chambers, the catalyst is more quickly exhausted at the gas inlet side, i.e., in the unit chamber positioned close to the upper portion of the nitrogen oxide reduction chamber 1221 and the ammonia reduction chamber 1222, and the use of the catalyst in the unit chamber is slowed toward the lower portion.

Accordingly, by varying the catalyst supply cycle according to the use of catalyst in each of the plurality of unit chambers of the nitrogen oxide reduction chamber 1221 and the ammonia reduction chamber 1222, the efficiency of reaction in the reaction chamber 122 can be maximized and management cost can be minimized.

The post-treatment unit 130 is provided to control temperature and pressure of a discharge gas by the post-treatment of the gas passed through the reaction unit 120, and ensures that the temperature and pressure are decreased to proper degrees before discharging the gas after nitrogen oxide and ammonia reduction.

According to one embodiment, as shown in FIG. 5, the post-treatment unit 130 may include a heat exchanger 131 for lowering the temperature of the gas to a preset degree that is proper for the discharge of the gas, and a blower 132 for adjusting the pressure of the discharged gas.

FIG. 6 is a view showing an implementation of a nitrogen oxide reduction system according to an embodiment.

Referring to FIG. 6, in the nitrogen oxide reduction system 100 according to an embodiment, the powder filter 111, the chemical filter 112, the heater 121, the reaction chamber 122, the heat exchanger 131 and the blower 132 may be connected in order along the flow of gas movement, such that the gas can be discharged at proper temperature and pressure after the powder, the chemical gas, the nitrogen oxide and the ammonia are sequentially removed.

Further, each component of the nitrogen oxide reduction system 100 may be configured to be included in a main body housing system (not shown) provided for housing the components. In this case, among the components of the nitrogen oxide reduction system 100, the components required to be separated for regular maintenance, that is, the powder filter 111, the chemical filter 112, or the reaction chamber 122 for example, are not mounted on a lower surface of the housing system, but instead moved horizontally from the side of the housing system and coupled to the lower surface of the housing system. Accordingly, maintenance work of the nitrogen oxide reduction system 100 can be more convenient and safety can be ensured.

## Claims

1. A nitrogen oxide reduction system, comprising:
a pre-treatment unit for reducing particulate matter and chemical gas included in an introduced gas by a pre-treatment of the gas;
a reaction unit for reducing nitrogen oxide and ammonia from the gas passed through the pre-treatment unit; and
a post-treatment unit for controlling temperature and pressure of a discharged gas by a post-treatment of the gas passed through the reaction unit, wherein the reaction unit comprises
a heater for heating the gas to a preset temperature range; and
a reaction chamber connected in back of the heater to reduce nitrogen oxide and ammonia.

2. The system of claim 1, wherein the reaction chamber comprises:
a nitrogen oxide reduction chamber for reducing nitrogen oxide; and
an ammonia reduction chamber for reducing ammonia, wherein the nitrogen oxide reduction chamber and the ammonia reduction chamber are configured as an integrated structure wherein a plurality of catalyst chambers are coupled to each other in a stacked manner.

3. The system of claim 2, wherein the nitrogen oxide reduction chamber and the ammonia reduction chamber are coupled such that the nitrogen oxide reduction chamber is positioned above, and the nitrogen oxide reduction chamber is positioned under, and
the gas heated with the heater is introduced from an upper portion of the nitrogen oxide reduction chamber and moved to a lower portion while passing through the ammonia reduction chamber.

4. The system of claim 2, wherein at least one of the nitrogen oxide reduction chamber and the ammonia reduction chamber is configured such that a plurality of unit chambers formed as modules are coupled to each other in a stacked manner.

5. The system of claim 1, wherein the pre-treatment unit comprises:
a powder filter for removing powder in the gas; and
a chemical filter for removing chemical gas, the chemical filter being connected in back of the powder filter,
wherein the powder filter and the chemical filter are connected in parallel lines to form a dual configuration.

6. The system of claim 5, wherein each component of the nitrogen oxide reduction system is housed in a main body housing system, and
at least one of the powder filter, the chemical filter, and the reaction chamber are move in a horizontal direction from a side of the housing system and coupled to a lower surface of the housing system.
